(19) Europäisches Patentamt

European Patent Office

Office européen des brevets

(11) EP 0 730 204 A1

(12) EUROPEAN PATENT APPLICATION

(43) Date of publication:
04.09.1996 Bulletin 1996/36

(51) Int Cl.⁶: **G03F 7/20**

(21) Application number: 96301425.3

(22) Date of filing: 01.03.1996

(84) Designated Contracting States:
DE FR GB

(30) Priority: 03.03.1995 KR 9504379

(71) Applicant: Samsung Electronics Co., Ltd.
Suwon-City, Kyungki-do 441-742 (KR)

(72) Inventors:
• Kim, Kee-ho
Seoul (KR)
• Kim, Cheol-hong
Suwon-city, Kyungki-do (KR)
• Han, Woo-sung
Suwon-city, Kyungki-do (KR)

(74) Representative: Lawrence, Richard Anthony et al
Elkington & Fife,
Prospect House,
8 Pembroke Road
Sevenoaks, Kent TN13 1XR (GB)

(54) **Auto-aperture apparatus**

(57)    An auto-aperture apparatus for controlling a coherence factor includes an iris aperture (110), and driving motors (120,130,140) for automatically controlling the iris aperture. The driving motors comprise X- and Y-axis motors (130,140) for moving the centre of the iris aperture finely along an X-axis and a Y-axis, respectively, and a motor (120) for controlling the radius of the iris aperture (110). The radius of the aperture is altered successively by automatic control of the aperture (110), and the centre of the aperture itself is moved finely along the X- and Y-axes. Thus, fine alignment to the optical axis of any stepper is possible.

FIG.3

## Description

The present invention relates to an auto-aperture apparatus for automatically controlling the coherence factor of a stepper used in lithographic processing for a semiconductor device.

In semiconductor lithography, resolution and depth-of-focus (DOF) are dependent on the coherence factor. The coherence factor σ is defined by:

$$\sigma = \ell d / NA$$

where $\ell d$ is the diameter of an optical image projected on the entrance pupil of a projection lens by a condenser lens, and NA is the numerical aperture of the projection lens.

Modified illumination methods and phase shift masks have recently attracted much attention, due to the capability that they can provide for enhancing resolution. In using these, however, there is a requirement that light interference be controlled by adjusting the coherence factor σ, according to their characteristics.

Generally, since a focal point created by a fly's-eye lens serves as a substantial light source of a stepper, the coherence factor σ is adjusted by an aperture disposed in front of the fly's eye lens in the stepper.

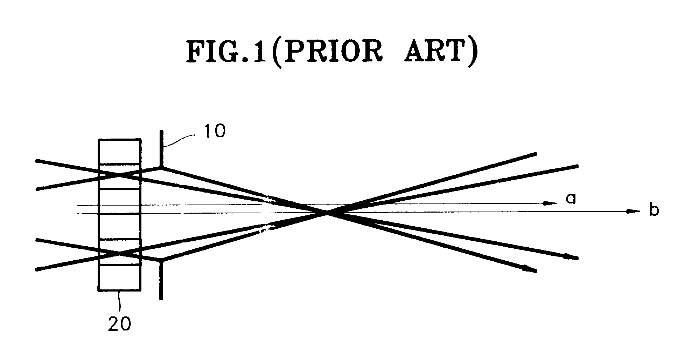

FIG. 1 is a view for explaining problems involved in a conventional aperture installing method. Reference numeral 10 denotes an aperture, and reference numeral 20 denotes a fly's-eye lens.

Referring to FIG. 1, illumination uniformity is likely to be reduced, because the optical axis a of **a** stepper cannot be finely aligned to an aperture axis **b** with such conventional technology.

In effort to adjust the coherence factor σ of a stepper, a plate type aperture and a wheel type aperture have recently been developed.

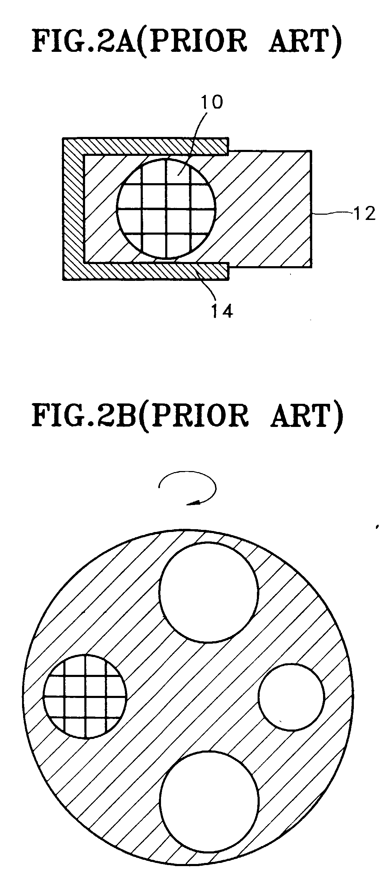

FIG. 2A illustrates plate type apertures. An aperture plate 12 having apertures 10 of various sizes installed thereon is provided detachably on an aperture mount 14.

FIG. 2B illustrates wheel type apertures. A wheel having apertures of various sizes is rotated for use of an intended aperture.

However, although the above types of apertures are employable in hardware when so prepared in advance, it is difficult to install such apertures later in equipment where provision of such apertures has not been considered in the development phase.

The following Table 1 reveals illumination uniformities measured in a stepper provided with conventional apertures. Here, "normal" is a sample of a stepper having no aperture. "gap" indicates the distance between an aperture and a fly's-eye lens, and "ang." indicates the angle of an aperture to eliminate scattered light at the sidewall of the aperture by diverging light past a fly's-eye lens.

Table 1

|  | normal | gap:0 ang.: small | gap:0 ang.: large | gap: 1mm ang.: small | gap: 1mm ang.: large | gap: 2mm ang: small | gap: 2mm ang.: large | gap: 3mm ang.: small |
|---|---|---|---|---|---|---|---|---|
| maximum intensity (mW/cm$^2$) | 403 | 307 | 332 | 306 | 312 | 310 | 318 | 299 |
| minimum intensity (mW/cm$^2$) | 388 | 280 | 304 | 279 | 284 | 282 | 290 | 273 |
| average intensity (mW/cm$^2$) | 395 | 296 | 322 | 295 | 302 | 299 | 308 | 290 |
| uniformity (%) | 1.9 | 4.6 | 4.4 | 4.62 | 4.7 | 4.73 | 4.61 | 4.55 |

The above Table 1 shows that the conventional apertures have the drawback that illumination uniformities worsen due to a shadow effect caused by the installation of the apertures and a distorted optical axis resulting from scattered light.

It is of particular importance in mass production, since many environmental conditions established after the set-up of a stepper in an earlier stage subsequently alter the optical axis, that the position of an aperture centre should be finely aligned, periodically, in accordance with the alteration. This fine alignment function, however, is not provided for the conventional apertures. Furthermore, the conventional apertures are limited in size.

The object of the present invention is to provide an auto-aperture apparatus for controlling a coherence factor to overcome the above-described problems of the conventional apertures.

To achieve the above object, there is provided an auto-aperture apparatus for controlling the coherence factor of a stepper, comprising, an iris aperture whose radius and center are varied by an external force; and driving means for automatically controlling the radius of said iris aperture and the centre thereof from the outside.

Preferably, said driving means for controlling the radius of said iris aperture comprises a radius controlling motor being a step motor and a bolt and a nut for linearly moving by the driving force of said radius controlling motor.

Preferably, said driving means for controlling the radius of said iris aperture comprises a radius controlling motor and a pulley coupled to the shaft of said radius controlling motor.

Preferably, said driving means for altering the center of said iris aperture comprises an X-axis driving motor for finely controlling the X-axis coordinate of the center of said aperture, and a Y-axis driving motor for finely controlling the Y-axis coordinate of the centre thereof.

More preferably, said driving means further comprises an X-axis guide coupled to said X-axis driving motor, and a Y-axis guide coupled to said Y-axis driving motor, so that the centre coordinates of said iris aperture are slidingly driven.

According to preferred embodiments of the present invention, the radius of the aperture can be successfully altered by automatically driving the aperture. In addition, since the centre of the aperture makes fine movements along X-and Y-axes, fine alignment to the optical axis of any stepper is possible.

Specific embodiments of the invention are described in detail below, by way of example, with reference to the attached drawings, in which:

FIG. 1 is a view for explaining problems involved in a conventional aperture installing method;

FIG. 2A illustrates conventional plate type apertures for controlling a coherence factor;

FIG. 2B illustrates conventional wheel type apertures for controlling a coherence factor;

FIG. 3 is a schematic view of a stepper employing an iris aperture in accordance with an embodiment of the present invention;

FIG. 4 is a detailed view of an auto-aperture apparatus for controlling a coherence factor according to an embodiment of the present invention; and

FIGS. 5 is detailed views of an auto-aperture apparatus for controlling a coherence factor according to another embodiment of the present invention.

Preferred embodiments of the present invention will be described in detail, referring to the attached drawings.

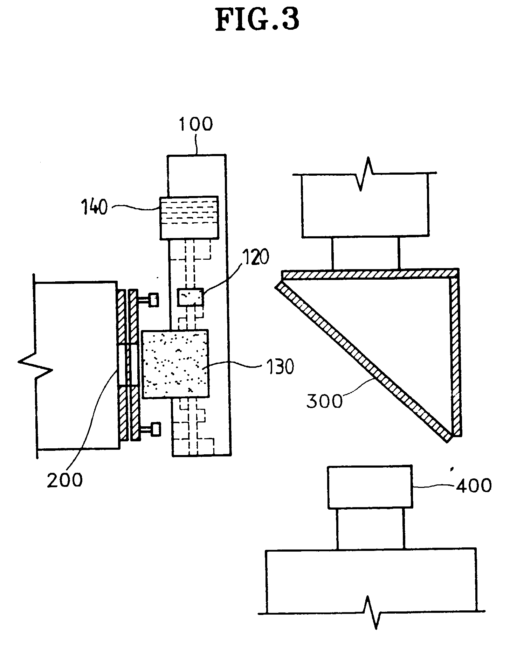

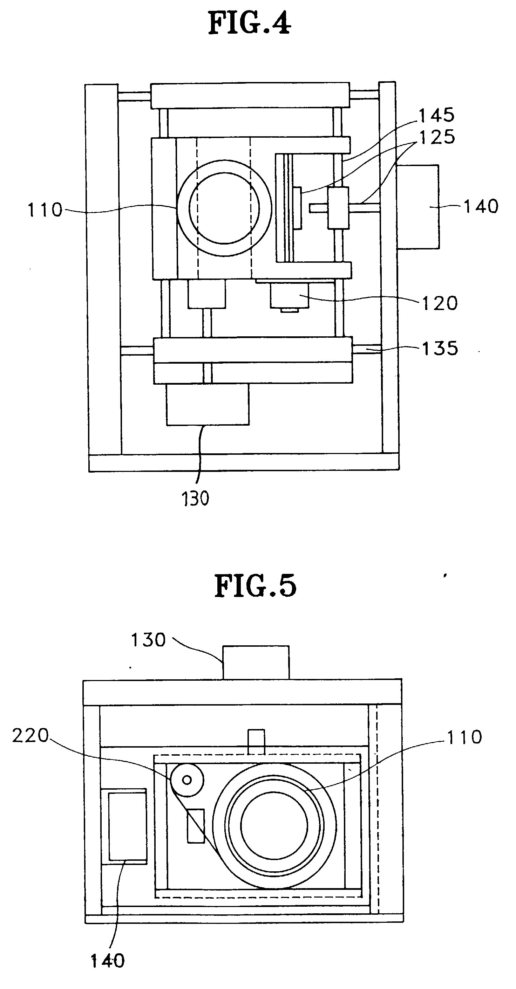

FIG. 3 schematically illustrates a stepper adopting an iris aperture according to the present invention. Reference numeral 200 denotes a fly's-eye lens, reference numeral 100 denotes an iris aperture disposed in front of the fly's-eye lens and driven by motors, reference numeral 300 denotes a beam splitter in the stepper, and reference numeral 400 denotes an energy monitoring system. The other reference numerals 120, 130 and 140 are stepper motors to be described later, referring to FIG. 4.

As shown in FIG. 3, auto-aperture apparatus according to embodiments of the present invention can be easily installed without modification of the conventional stepper.

An auto-aperture apparatus according to an embodiment of the present invention and operating in a guide sliding method will be described with reference to FIG. 4.

In FIG. 4, the auto-aperture apparatus of the present invention is comprised of an iris aperture 110 whose radius and center are changeable by a specific external force, and three driving units externally provided for automatically controlling the iris aperture 110.

Each of the driving units is comprised of a radius controlling motor 120 for controlling the radius of the iris aperture 110, a bolt/nut 125 which is linearly moved by the motor 120, and X- and Y-axis driving motors 130 and 140 for moving the center of the iris aperture 110 finely along X- and Y-axes, respectively.

In this embodiment, by means of the X- and Y-axis driving motors 130 and 140, the center of the iris aperture 110 can slide along guides 135 and 145 connected thereto, respectively.

In the auto-aperture apparatus for controlling a coherence factor according to embodiments of the present invention, the axis of the aperture 110 can be aligned to the optical axis of a stepper by fine movement of the centre of the iris aperture 110 by means of the X-and Y-axis driving motors 130 and 140. Here, the X- and Y-axis driving motors 130 and 140 cause the aperture to slide along the X- and Y-axis guides 135 and 145, respectively. Further, the radius of the iris aperture 110 experiences continuous adjustment by the radius controlling motor 120 and the bolt/nut 125, in the same manner as the centre of the aperture moves.

The radius controlling motor 120, the X-axis driving motor 130, and the Y-axis driving motor 140 may all be comprised of stepper motors.

According to the embodiment of the present invention, the radius of the aperture is altered within a limited range, since the radius of the iris aperture is adjusted by using the motor for generating a linear movement force.

FIGS. 5 is a detailed view of an auto-aperture apparatus for controlling a coherence factor according to another embodiment of the present invention, where the radius variable range of the iris aperture 110 is extended. In this case, a pulley 220 is coupled to a radius controlling motor shaft, thereby to control the radius of the iris aperture 110, and the centre of the iris aperture 110 is moved finely by the X-and Y-axis driving motors 130 and 140.

In this further embodiment of the present invention, no limit is placed on the radius adjustment, because the radius of the iris aperture 110 is adjusted by means of the motor and the pulley 220.

A controller (not shown) can be installed independently to control the auto-aperture apparatus.

The following Table 2 shows illumination uniformities measured after an auto-aperture apparatus of the present invention and a conventional aperture are installed in steppers.

Table 2

|  | maximum illumination | minimum illumination | average illumination | illumination uniformity (%) |
|---|---|---|---|---|
| conventional aperture (σ=0.5) | 658 | 626 | 639 | 2.49 |
| auto-aperture apparatus (σ=0.5) | 658 | 628 | 640 | 2.33 |
| manually fabricated aperture (σ=0.3) | 514 | 486 | 500 | 2.51 |
| auto-aperture apparatus (σ=0.3) | 512 | 488 | 502 | 2.4 |

Table 2 reveals that the illumination uniformity of the aperture of the present invention was considerably improved from that of the conventional aperture.

The reason for this is that the radius of the aperture can be altered in embodiments of the present invention, and its centre can be finely adjusted, thereby enabling fine alignment to the optical axis of a stepper of any kind, in contrast to the position for the conventional aperture.

As described above, the auto-aperture apparatus for controlling a coherence factor according to embodiments of the present invention is advantageous, in that fine alignment to the optical axis of any stepper is possible because the radius of the iris aperture is altered successively by automatically driving the iris aperture, so that its actual centre makes fine movements along the X- and Y-axes.

Another advantage of the auto-aperture apparatus of embodiments of the present invention is that it is easily installed, even in a conventional stepper, without placing therebetween any extra device.

Further, the radius of the aperture is successively variable in embodiments of the present invention, obviating any need for preparing as many conventional apertures as there are sizes required.

The present invention is not confined to the above embodiments, and it is clearly understood that many variations are possible within the scope of the present invention by anyone having ordinary skill in the art.

**Claims**

1. An auto-aperture apparatus for controlling the coherence factor of a stepper, comprising:

   an iris aperture (110) whose radius and centre are adapted to be varied by an external force; and
   driving means (120,130,140) for automatic control from the outside of both the radius and the centre of said iris aperture.

2. An auto-aperture apparatus as claimed in claim 1, wherein said driving means for controlling the radius of said iris aperture comprises a radius controlling motor (120) being a stepper motor.

3. An auto-aperture apparatus as claimed in claim 2, further comprising a bolt and a nut (125) adapted for linear motion in response to the driving force of said radius controlling motor.

4. An auto-aperture apparatus as claimed in claim 1, wherein said driving means for controlling the radius of said iris aperture comprises a radius controlling motor and a pulley (220) coupled to the shaft of said radius controlling motor.

5. An auto-aperture apparatus claimed in any preceding claim, wherein said driving means for altering the centre of said iris aperture comprises an X-axis driving motor (130) for fine control of the X-axis coordinate of the centre of said aperture (110), and a Y-axis driving motor (140) for fine control of the Y-axis coordinate of the centre of said aperture (110).

6. An auto-aperture apparatus claimed in claim 5, further comprising an X-axis guide (135) coupled to said X-axis driving motor (130), and a Y-axis guide (145) coupled to said Y-axis driving motor (140), so that the centre coordinates of said iris aperture (110) are variable by driving the aperture (110) to slide with respect to said guides (135,145).

7. An auto-aperture apparatus claimed in claim 5 or claim 6, wherein each of said X- and Y-axis driving motors (130,140) comprises a stepper motor.

FIG.1(PRIOR ART)

# FIG.2A(PRIOR ART)

# FIG.2B(PRIOR ART)

# FIG.3

# FIG.4

145
125
110
140
120
135
130

# FIG.5

130
220
110
140

European Patent Office

**EUROPEAN SEARCH REPORT**

Application Number

EP 96 30 1425

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | US-A-4 931 830 (SUWA KYOICHI ET AL) 5 June 1990<br>* column 3, line 14 - column 4, line 19 *<br>* figure 1 *<br>--- | 1 | G03F7/20 |
| A | DE-U-91 10 927 (MAX-PLANCK-GESELLSCHAFT ZUR FÖRDERUNG DER WISSENSCHAFTEN EV) 19 December 1991<br>* page 4 - page 5, paragraph 1 *<br>* figures *<br>--- | 1 | |
| A | US-A-4 316 189 (STURGES JR ROBERT H) 16 February 1982<br>* column 2, line 28 - column 5 *<br>* figures *<br>--- | 1 | |
| A | US-A-5 160 962 (MIURA SEIYA ET AL) 3 November 1992<br>* column 3, line 4 - line 57 *<br>* figure 1 *<br>----- | 1 | |
| | | | **TECHNICAL FIELDS SEARCHED (Int.Cl.6)**<br><br>G03F<br>G02B |

The present search report has been drawn up for all claims

| Place of search | Date of completion of the search | Examiner |
|---|---|---|
| THE HAGUE | 10 June 1996 | Heryet, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)